# EUROPEAN PATENT APPLICATION

(11) **EP 4 770 338 A2**
(43) Date of publication of application: **01.07.2026**
(21) Application number: 26179009.1
(22) Date of filing: 15.05.2026
(51) Int. Cl.: H10F 10/14, H10F 71/00, H10F 77/14

(54) **PHOTOVOLTAIC CELL AND PHOTOVOLTAIC MODULE**

(30) Priority: 13.01.2026 CN 202610039508
(71) Applicant: Jinko Solar (Haining) Co., Ltd., Haining City, Zhejiang 314415 (CN)
(72) Inventor: WANG, Zhao, 314415 Haining City (CN); ZHANG, Yuanfang, 314415 Haining City (CN); LIU, Feng, 314415 Haining City (CN); XIA, Luyao, 314415 Haining City (CN); ZHANG, Xinyu, 314415 Haining City (CN); YANG, Jie, 314415 Haining City (CN); ZHENG, Peiting, 314415 Haining City (CN)
(74) Representative: Ipsilon

(57) **Abstract**

A photovoltaic cell includes a silicon substrate (10), a doped region (20) and a first electrode (30). The silicon substrate (10) has a first surface (11) and a second surface (12) opposite to each other. The first surface (11) defines a first region (13) and a second region (14), the doped region (20) is located in the first surface (11) in the first region (13). The first electrode (30) is electrically connected to the doped region (20); and the silicon substrate (10) is provided with a groove (15) in the second region (14). In a thickness direction of the silicon substrate (10), a depth of the groove (15) is in a range of 1.5µm to 3µm.

## Description

### TECHNICAL FIELD

The present invention relates to the field of photovoltaic technologies, and in particular, to a photovoltaic cell, a manufacturing method thereof, and a photovoltaic module.

### BACKGROUND

Silicon-based photovoltaic cells are currently the most widely used photovoltaic cells. In a silicon-based photovoltaic cell, P-type silicon and N-type silicon are formed by doping, and a PN junction is formed at a junction of the two to generate a built-in electric field. Under the action of the built-in electric field, photogenerated carriers move towards the N region, and holes move towards the P region, thereby achieving the separation of carriers. When the external circuit is closed, the separated electrons and holes flow in the circuit to form a current, thereby realizing the conversion of solar energy into electrical energy.

### SUMMARY

According to various embodiments, a photovoltaic cell, a manufacturing method thereof, and a photovoltaic module are provided.

According to a first aspect, a photovoltaic cell is provided, including a silicon substrate having a first surface and a second surface that are opposite to each other, the first surface defining a first region and a second region, and the silicon substrate being provided with a groove in the second region; a doped region located in the first surface and in the first region; and a first electrode electrically connected to the doped region; in a thickness direction of the silicon substrate, a depth of the groove is in a range of 1.5µm to 3 µm.

In one embodiment, a doping concentration of the doped region being in a range of 1.2× 10²⁰ cm⁻³ to 1.5×10²⁰cm⁻³.

In one embodiment, a thickness of the doped region is in a range of from 100 nm to 300 nm.

In one embodiment, the first surface has a textured structure, and the textured structure comprises a plurality of pyramid structures.

In one embodiment, radial widths of the plurality of pyramid structures gradually decrease in a direction away from the second surface.

In one embodiment, in the doped region, a doping concentration of a portion located at a bottom end of one of the plurality of pyramid structures is less than or equal to a doping concentration of a portion located at a top end of the pyramid structure.

In one embodiment, in the doped region, a difference between a doping concentration of the portion located at the bottom end of the pyramid structure and the doping concentration of the portion located at the top end of the pyramid structure is less than or equal to 1× 10²⁰ cm⁻³ .

In one embodiment, a width of the first region is greater than or equal to a width of the first electrode.

In one embodiment, the photovoltaic cell further includes a tunneling oxide layer and a doped silicon layer that are sequentially stacked on the second surface, and a plurality of second electrodes provided on the doped silicon layer, wherein the plurality of second electrodes are electrically connected to the doped silicon layer.

In one embodiment, a doping type of the doped region is P-type, and a doping type of the doped silicon layer is N-type.

In one embodiment, a width of the doped silicon layer is greater than or equal to a width of the second electrode.

In one embodiment, a doping concentration of the doped silicon layer is in a range of 1× 10¹⁹ cm⁻³ to 5×10²⁰cm⁻³.

In one embodiment, the second surface defines a third region and a fourth region, the photovoltaic cell further comprises a tunneling oxide layer, a doped silicon layer, and a second electrode that are sequentially stacked on the second surface and located in the third region, and the second electrode is electrically connected to the doped silicon layer.

In one embodiment, the third region completely corresponds to or does not completely correspond to the first region.

In one embodiment, the fourth region completely corresponds to or does not completely correspond to the second region.

In one embodiment, the tunneling oxide layer, the doped silicon layer, and the second electrode are not disposed in the fourth region.

In one embodiment, a doping type of the doped region is P-type, and a doping type of the doped silicon layer is N-type.

In one embodiment, a width of the doped silicon layer is greater than or equal to a width of the second electrode.

In one embodiment, a doping concentration of the doped silicon layer is in a range of 1×10¹⁹ cm⁻³ to 5×10²⁰cm⁻³.

According to a second aspect, a method for manufacturing a photovoltaic cell is provided, including: providing a silicon substrate, the silicon substrate having a first surface and a second surface opposite to each other, the first surface including a first region and a second region; performing a first deposition on the first surface; performing a first drive-in treatment; performing a second deposition on the first surface; and performing a second drive-in treatment; performing a laser heat treatment on the first surface located in the second region; and performing a first etching treatment on an entire surface of the first surface by using a first alkaline solution, so as to form a groove in a portion of the first surface located in the first region.

In one embodiment, the first drive-in treatment reduces the concentration of the doping element on the first surface by more than 30%.

In one embodiment, the first drive-in treatment enables the doping element to have a depth of 50 nm to 150 nm into the substrate.

In one embodiment, the second drive-in treatment enables the doping element to have a depth of 50 nm to 100 nm into the substrate.

In one embodiment, after performing the second drive-in treatment and prior to performing a laser heat treatment, the method further includes: performing a third deposition on the first surface; performing a third drive-in treatment; performing a fourth deposition on the first surface; and performing a fourth drive-in treatment.

In one embodiment, the laser heat treatment causes the doping element to defuse into the silicon substrate to a depth of 1.4µm or more.

In one embodiment, the laser heat treatment reduces a doping concentration at the first surface in the second region to less than 25% of a doping concentration after the first deposition.

In one embodiment, the first etching process reduces the thickness of the silicon substrate in the second region by 1.5µm to 3µm.

According to a third aspect, a photovoltaic module is provided, including: a cover plate; at least one cell string including the photovoltaic cell according to any one of forgoing embodiments; and an encapsulation layer located between the cover plate and the at least one cell string, and the cover plate being connected to the at least one cell string through the encapsulation layer.

In the above method for manufacturing the photovoltaic cell, the cyclic treatment is performed on the first surface of the silicon substrate, the doping concentration of the doping element deposited first to the first surface in the cyclic treatment is close to saturation and then the drive-in treatment is performed, and the doping concentration of the doping element deposited at the first surface is close to saturation and the second drive-in treatment is performed again, so that the doped silicon region with the higher doping concentration with the higher uniformity and the doping concentration close to saturation can be formed in the first surface. Further, the laser heat treatment is performed on the first surface located in the second region, so that the doping element located in the second region can continue to diffuse into the silicon substrate, thereby reducing the doping concentration at the first surface located in the second region, and the first region that is not subjected to the laser heat treatment remains in a nearly saturated doping state. Then, the first alkaline solution is used to perform the first etching treatment on the entire surface of the first surface, the first alkaline solution has a faster etching rate for the doped silicon in the second region with a lower doping concentration, and the doped silicon in the first region has more lattice defects in a near-saturated doping state, the etching rate is slow, at the same time, the increase of the lattice defects will cause the surface to be non-hydrophobic, and the organic active molecules in the first alkaline solution will be adsorbed on the surface in the first region to block the etching of the doped silicon by the alkali, so that local etching can be realized to form grooves in the second region, thereby obtaining the patterned doped silicon region. The doped silicon that is not etched on the first surface is used as a doped region, which has a higher doping concentration, and is used for contact with the electrode, and the higher doping concentration facilitates carrier transport. The region where the groove is formed on the first surface is etched due to the low doping concentration, which can reduce carrier recombination when used as a non-metal region. That is, the manufacturing method of the photovoltaic cell of the present application can prepare the doped silicon region to have a local uniform high doping concentration in the region in contact with the electrode, thereby achieving high conversion efficiency of the photovoltaic cell.

### BRIEF DESCRIPTION OF THE DRAWINGS

The components in the drawings are not necessarily drawn to scale, the emphasis instead being placed upon clearly illustrating the principles of the present invention. Moreover, in the drawings, like reference numerals designate corresponding parts throughout the views.
FIG. 1 is a schematic view of a photovoltaic cell according to an embodiment of this application;
FIG. 2 is a schematic view of a photovoltaic cell according to another embodiment of this application;
FIG. 3 is a graph of a relationship between a doping concentration and a doping depth in Example 1;
FIG. 4 is a test result diagram of a groove depth in Example 1.

### Detailed description

10 silicon substrate; 11 first surface; 12 second surface; 13 first region; 14 second region; 15 recess; 20 doped region; 30 first electrode; 40 tunneling oxide layer; 50 doped silicon layer; 60 second electrode.

### DETAILED DESCRIPTION OF THE EMBODIMENTS

To make the foregoing objectives, features, and advantages of this application more comprehensible, the following describes specific embodiments of this application in detail. In the following description, numerous specific details are set forth in order to provide a thorough understanding of the present invention. However, the present application can be implemented in many other ways different from those described herein, and those skilled in the art can make similar improvements without departing from the connotation of the present application, so the present application is not limited by the specific embodiments disclosed below.

Unless otherwise defined, all technical and scientific terms used herein have the same meaning as commonly understood by those skilled in the art to which this application belongs. The terms used in the specification of the present application herein are only for the purpose of describing specific embodiments, and are not intended to limit the present application. As used herein, the term "and/or" includes any and all combinations of one or more of the associated listed items.

In the description of the present application, it should be understood that the orientation or positional relationship indicated by the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. is based on the orientation or positional relationship shown in the drawings, and is only for the convenience of describing the present application and simplifying the description, rather than indicating or implying that the device or element referred to must have a particular orientation, be constructed and operated in a particular orientation, and therefore cannot be construed as limiting the present application.

In addition, the terms "first" and "second" are only used for descriptive purposes, and cannot be understood as indicating or implying relative importance or implicitly indicating the number of indicated technical features. Therefore, features defined with "first" and "second" may explicitly or implicitly include at least one of the features. In the description of the present application, "a plurality of" means at least two, such as two, three, etc., unless otherwise specifically defined.

In the present application, unless otherwise expressly specified and limited, the terms "mounted", "connected", "connected", "fixed" and the like should be understood in a broad sense, for example, it may be a fixed connection, a detachable connection, or an integral connection; it may be a mechanical connection or an electrical connection; it may be a direct connection or an indirect connection through an intermediate medium; it may be an internal communication between two elements or an interaction relationship between two elements, unless otherwise expressly limited. A person of ordinary skill in the art may understand specific meanings of the foregoing terms in this application based on a specific situation.

In the drawings, the thickness of lavers, films, panels, regions, etc., are exaggerated for clarity. Like reference numerals designate like elements throughout the speciation. It will be understood that when an element such as a layer, film, region, or substrate is referred to as being "on" another element, it can be directly on the other element or intervening elements may also be present. In contrast, when an element is referred to as being "directly on" another element, there are no intervening elements present.

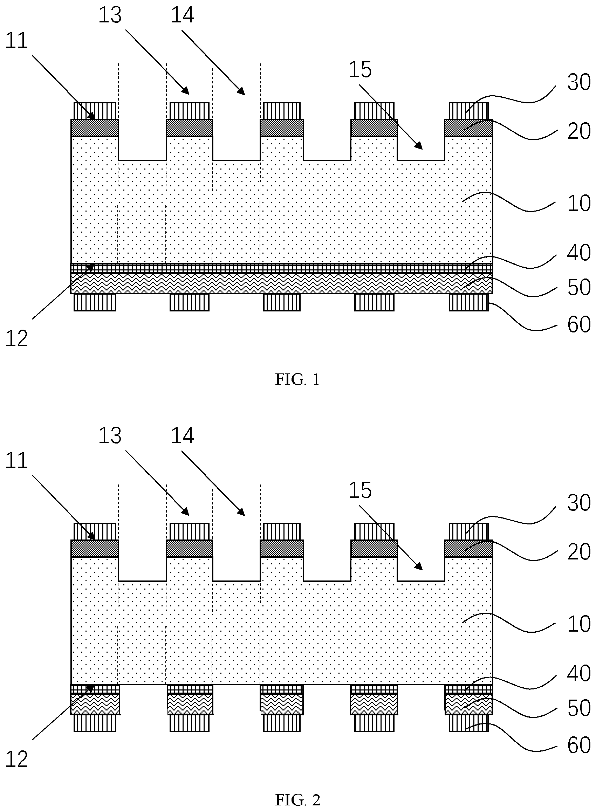

Referring to FIG. 1, an embodiment of present invention provides a photovoltaic cell, including a silicon substrate 10, a doped region 20, and a first electrode 30. The silicon substrate 10 has a first surface 11 and a second surface 12 that are disposed opposite to each other. The first surface 11 defines a first region 13 and a second region 14. The doped region 20 is located in the first surface 11 and in the first region 13. The first electrode 30 is electrically connected to the doped region 20; and the silicon substrate 10 is provided with a groove 15 in the second region 14.

It should be understood that the main concept of the silicon-based photovoltaic cell is to separate photo-generated carriers through the PN junction, and the non-electrode region is the main generation region of photo-generated carriers. If there is an unnecessary doped silicon region in the non-electrode region, a large number of recombination centers will be introduced, resulting in loss of photo-generated carriers. In the aforementioned photovoltaic cell, the first region 13 serves as an electrode region, and the width of the first region 13 is greater than or equal to the width of the first electrode 30. The doped region 20 with a higher doping concentration is provided in the first region and is electrically connected to the first electrode 30. The second region 14 serves as a non-electrode region and is provided with the groove 15. The doped silicon region of the forgoing photovoltaic cell has a locally uniform high doping concentration in a region in contact with the electrode, such that a higher conversion efficiency of the photovoltaic cell can be achieved.

In one embodiment, a doping concentration of the doped region 20 is in a range of 1.2× 10²⁰ cm⁻³ to1.5×10²⁰cm⁻³.

It should be noted that the doping concentration used herein refers to the effective doping concentration measured by ECV.

Optionally, the doping concentration of the doped region 20 can be 1.2×10²⁰cm⁻³, 1.22×10²⁰cm⁻³, 1.24×10²⁰cm⁻³, 1.26×10²⁰cm⁻³, 1.28×10²⁰cm⁻³, 1.3×10²⁰cm⁻³, 1.32×10²⁰cm⁻³, 1.34×10²⁰cm⁻³, 1.36×10²⁰cm⁻³, 1.38×10²⁰cm⁻³, 1.4×10²⁰cm⁻³, 1.42×10²⁰cm⁻³, 1.44×10²⁰cm⁻³, 1.46×10²⁰cm⁻³, 1.48×10²⁰cm⁻³ or 1.5×10²⁰cm⁻³. Alternatively, the doping concentration of the doped region 20 may be within a range between any two of the above doping concentrations.

In some embodiments, along the thickness direction of the silicon substrate 10, the depth of the groove 15 is in a range of 1.5µm to 3µm.

It should be noted that, when the depth of the groove 15 is within the range above, it is convenient to enhance the light trapping effect of the first surface 11, and at the same time, the light shielding caused by excessive depth of the groove 15, that is, excessive height of the doped region 20 and the first electrode 30, can be avoided, so as to ensure high conversion efficiency of the photovoltaic cell. Optionally, along the thickness direction of the silicon substrate 10, the depth of the groove 15 may be 1.5µm, 1.6µm, 1.7µm, 1.8µm, 1.9µm, 2µm, 2.1µm, 2.2µm, 2.3µm, 2.4µm, 2.5µm, 2.6µm, 2.7µm, 2.8µm, 2.9µm or 3µm. Alternatively, along the thickness direction of the silicon substrate 10, the depth of the groove 15 may also be within a range between any two of the above depths.

In some embodiments, the thickness of the doped region 20 ranges from 100 nm to 300 nm.

Optionally, the thickness of the doped region 20 may be 100 nm, 120 nm, 140 nm, 160 nm, 180 nm, 200 nm, 220 nm, 240 nm, 260 nm, 280 nm or 300 nm. Alternatively, the thickness of the doped region 20 may also be within a range between any two of the above thicknesses.

In some embodiments, the first surface 11 has a textured structure, and the textured structure includes a plurality of pyramid structures. In a direction away from the second surface 12, radial widths of the plurality of pyramid structures gradually decrease.

In some embodiments, in the doped region 20, a doping concentration of a portion located at a bottom end of the pyramid structure is less than or equal to a doping concentration of a portion located at a top end of the pyramid structure. Further, in the doped region 20, a difference between the doping concentration of the portion located at the bottom end of the pyramid structure and the doping concentration of the portion located at the top end of the pyramid structure is less than or equal to 1× 10²⁰ cm⁻³.

It can be understood that the photovoltaic cell structure of the present application can also be implemented on a textured surface. In the conventional photovoltaic cell, since the doping source is difficult to enter the bottom of the pyramid, a doped silicon region with a doping concentration much lower than that of the top of the pyramid structure is usually formed, that is, the doping uniformity of the doped silicon region is poor. In the present invention, in the doped region 20, the difference between the doping concentration of the portion located at the bottom end of the pyramid structure and the doping concentration of the portion located at the top end of the pyramid structure is less than or equal to 1× 10²⁰ cm⁻³, that is, the doped region 20 of the present invention has a high doping concentration with high uniformity, which facilitates achieving high conversion efficiency of the photovoltaic cell. Optionally, in the doped region 20, the difference between the doping concentration of the portion at the bottom end of the pyramid structure and the doping concentration of the portion at the top end of the pyramid structure is 0, 1×10¹⁶ cm⁻³, 1×10¹⁷cm⁻³, 0.5×10¹⁸cm⁻³, 1×10¹⁸cm⁻³, 0.2×10¹⁹cm⁻³, 0.5×10¹⁹cm⁻³, 1×10¹⁹cm⁻³, 0.2×10²⁰cm⁻³, 0.5×10²⁰cm⁻³ or 1× 10²⁰ cm⁻³. Alternatively, in the doped region 20, the difference between the doping concentration of the portion at the bottom end of the pyramid structure and the doping concentration of the portion at the top end of the pyramid structure may also be within a range between any two of the above differences.

In some embodiments, a tunneling oxide layer 40 and a doped silicon layer 50 are sequentially stacked on the second surface 12. A plurality of second electrodes 60 are provided on the doped silicon layer 50, and the second electrodes 60 are electrically connected to the doped silicon layer 50. The doping type of the doped region 20 is P-type; and the doping type of the doped silicon layer 50 is N-type.

Referring to FIG. 2, in some embodiments, the second surface 12 includes a third region and a fourth region, the tunneling oxide layer 40, the doped silicon layer 50, and the second electrodes 60 are disposed in the third region, and the tunneling oxide layer 40, the doped silicon layer 50, and the second electrodes 60 are not disposed in the fourth region.

It can be understood that the tunneling oxide layer 40 and the doped silicon layer 50 may be formed on the entire surface of the back surface of the photovoltaic cell, or the patterned tunneling oxide layer 40 and the patterned doped silicon layer 50 may be formed on the back surface. The third region may or may not completely correspond to the first region. The patterned tunneling oxide layer 40 and the doped silicon layer 50 may be prepared by any preparation method that may be implemented in the art, which is not limited herein. Exemplarily, the patterned tunneling oxide layer 40 and the doped silicon layer 50 may be obtained by preparing the tunneling oxide layer 40 and the doped silicon layer 50 on the entire surface and then performing laser etching.

In some embodiments, the width of the doped silicon layer 50 is greater than or equal to the width of the second electrode 60.

In some embodiments, the doping concentration of the doped silicon layer 50 is in a range of 1× 10¹⁹ cm⁻³ to 5×10²⁰cm⁻³.

Optionally, the doping concentration of the doped silicon layer 50 is 1× 10¹⁹ cm⁻³, 2×10¹⁹cm⁻³, 5×10¹⁹cm⁻³, 8×10¹⁹em⁻³, 1×10²⁰cm⁻³, 2×10²⁰cm⁻³, 3×10²⁰cm⁻³, 4×10²⁰cm⁻³ or 5× 10²⁰ cm⁻³. Alternatively, the doping concentration of the doped silicon layer 50 may be within a range between any two of the above doping concentrations.

Another embodiment of the present application provides a method for manufacturing a photovoltaic cell, including the following steps:

Providing a silicon substrate 10, the silicon substrate 10 having a first surface 11 and a second surface 12 opposite to each other, the first surface 11 including a first region 13 and a second region 14.

Performing a cyclic treatment on the first surface 11, and the cyclic treatment includes the following steps: performing a first deposition on the first surface 11; performing a first drive-in treatment; performing a second deposition on the first surface 11; and performing a second drive-in treatment.

Performing a laser heat treatment on the first surface 11 located in the second region 14.

Performing a first etching treatment on the entire surface of the first surface 11 by using a first alkaline solution, so as to form a groove 15 in a portion of the first surface 11 located in the second region 14.

In the above method for manufacturing a photovoltaic cell, the cyclic treatment is performed on the first surface 11 of the silicon substrate 10, a doping concentration of a doping element deposited first on the first surface 11 in the cyclic treatment is close to saturation and then a drive-in treatment is performed, and a doping concentration of the doping element deposited on the first surface 11 is close to saturation and a second drive-in treatment is performed again, so that a doped silicon region with a higher doping concentration with higher uniformity and a doping concentration close to saturation can be formed on the first surface 11. Further, the laser heat treatment is performed on the first surface 11 located in the second region 14, so that the doping element located in the second region 14 continues to diffuse into the silicon substrate 10, thereby reducing the doping concentration at the first surface 11 located in the second region 14, and the first region 13 that is not subjected to the laser heat treatment remains in a near-saturated doping state. Then, the first alkaline solution is used to perform the first etching treatment on the entire surface of the first surface 11, the first alkaline solution has a faster etching rate for the doped silicon in the second region 14 with a lower doping concentration, and the doped silicon in the first region 13 has more lattice defects in a near-saturated doping state, the etching rate is slow, and at the same time, the increase of the lattice defects will cause the surface to be non-hydrophobic, and the organic active molecules in the first alkaline solution will be adsorbed on the surface in the first region 13 to block the etching of the doped silicon by the alkali, so that local etching can be realized to form the groove 15 in the second region 14, thereby obtaining the patterned doped silicon region. The non-etched doped silicon on the first surface 11 serves as the doped region 20, and has a higher doping concentration for contact with the electrode, and the higher doping concentration facilitates carrier transport. The region where the groove 15 is formed on the first surface 11 is etched due to the low doping concentration, which can reduce carrier recombination when used as a non-metal region. That is, the manufacturing method of the photovoltaic cell of the present application can prepare the doped silicon region to have a local uniform high doping concentration in the region in contact with the electrode, thereby achieving high conversion efficiency of the photovoltaic cell.

In some embodiments, the first deposition is performed on the first surface 11, so as to make the doping concentration of the doping element at the first surface 11 to close to saturation.

In some embodiments, the second deposition is performed on the first surface 11, so as to make the doping concentration of the doping element at the first surface 11 close to saturation.

In some embodiments, the first drive-in treatment reduces the concentration of the doping element on the first surface 11 by more than 30%.

The first drive-in treatment reduces the concentration of the doping element on the first surface 11 by more than 30%, which facilitates the formation of a doped silicon region with a higher doping concentration with higher uniformity and a doping concentration close to saturation on the first surface 11 by cyclic treatment.

In some embodiments, the first drive-in treatment reduces the concentration of the doping element on the first surface 11 to 2× 10¹⁹ cm⁻³ to 1×10²⁰cm⁻³.

Optionally, the first drive-in treatment reduces the concentration of the doping element on the first surface 11 to 2× 10¹⁹ cm⁻³ , 3×10¹⁹cm⁻³, 4×10¹⁹cm⁻³, 5×10¹⁹cm⁻³, 6×10¹⁹cm⁻³, 7×10¹⁹cm⁻³, 8×10¹⁹cm⁻³, 9×10¹⁹cm⁻³ or 1× 10²⁰ cm⁻³. Alternatively, the first drive-in treatment reduces the concentration of the doping element on the first surface 11 to a range between any two of the above doping concentrations.

In some embodiments, the first drive-in treatment enables the doping element to have a depth of 50 nm to 150 nm into the substrate.

Optionally, the first drive-in treatment enables the depth of the doping element into the substrate to be 50 nm, 60 nm, 70 nm, 80 nm, 90 nm, 100 nm, 110 nm, 120 nm, 130 nm, 140 nm or 150 nm. Alternatively, the first drive-in treatment enables the depth of the doping element into the substrate to be within a range between any two of the above depths.

In some embodiments, the second drive-in treatment enables the doping element to have a depth of 50 nm to 100 nm into the substrate.

Optionally, the second drive-in treatment enables the depth of the doping element into the substrate to be 50 nm, 55 nm, 60 nm, 65 nm, 70 nm, 75 nm, 80 nm, 85 nm, 90 nm, 95 nm or 100 nm. Alternatively, the second drive-in treatment enables the depth of the doping element into the substrate to be within a range between any two of the above depths.

In the range of the depth of the doping element deep into the substrate by the first drive-in treatment and the depth of the doping element deep into the substrate by the second drive-in treatment, it is convenient to prepare the doping region 20 with a suitable doping concentration and doping depth, thereby achieving high conversion efficiency of the photovoltaic cell.

In some embodiments, the number of cycle treatment is multiple.

In some embodiments, the laser heat treatment causes the doping element to defuse into the silicon substrate 10 to a depth of 1.4µm or more.

The laser heat treatment makes the depth of the doping element into the silicon substrate 10 reach 1.4µm or more, which is convenient for preparing the groove 15 with a depth of 1.5µm to 3µm by subsequent alkaline solution etching. Optionally, the depth of the doping element deep into the silicon substrate 10 by laser heat treatment is 1.4µm to 2.8µm, further optionally, the depth of the doping element deep into the silicon substrate 10 by laser heat treatment is 1.4µm, 1.6µm, 1.8µm, 2µm, 2.2µm, 2.4µm, 2.6µm or 2.8µm. Alternatively, the depth of the doping element deep into the silicon substrate 10 by laser heat treatment may also be within a range between any two of the above depths.

In some embodiments, the laser heat treatment reduces the doping concentration at the first surface 11 in the second region 14 to less than 25% of the doping concentration after the first deposition.

The laser heat treatment reduces the doping concentration at the first surface 11 in the second region 14 to below 25% of the doping concentration after the first deposition, which facilitates the subsequent etching of the alkali solution to prepare the groove 15 with a depth of 1.5µm to 3µm, improves the etching rate of the second region 14, reduces the etching time, and reduces the damage to the first region 13. Optionally, the laser heat treatment reduces the doping concentration at the first surface 11 in the second region 14 to below 20% of the doping concentration after the first deposition, or reduces the doping concentration at the first surface 11 in the second region 14 to below 15% of the doping concentration after the first deposition, or reduces the doping concentration at the first surface 11 in the second region 14 to below 10% of the doping concentration after the first deposition.

In some embodiments, the first etching process reduces the thickness of the silicon substrate 10 in the second region 14 by 1.5µm to 3µm.

Optionally, the first etching treatment causes the silicon substrate 10 in the second region 14 to be thinned by 1.5µm, 1.6µm, 1.7µm, 1.8µm, 1.9µm, 2µm, 2.1µm, 2.2µm, 2.3µm, 2.4µm, 2.5µm, 2.6µm, 2.7µm, 2.8µm, 2.9µm, or 3µm. Alternatively, the first etching treatment causes the silicon substrate 10 in the second region 14 to be thinned by a thickness in a range between any two of the above thicknesses.

Another embodiment of the present application provides a method for manufacturing a photovoltaic cell, including the following steps:

Providing a silicon substrate 10, the silicon substrate 10 having a first surface 11 and a second surface 12 opposite to each other, the first surface 11 including a first region 13 and a second region 14.

Performing a first deposition on the first surface 11; performing a first drive-in treatment; performing a second deposition on the first surface 11; and performing a second drive-in treatment.

Performing a laser heat treatment on the first surface 11 located in the second region 14.

Performing a first etching treatment on the entire surface of the first surface 11 by using a first alkaline solution, so as to form a groove 15 in a portion of the first surface 11 located in the second region 14.

In some embodiments, after performing the second drive-in treatment and prior to performing a laser heat treatment, the method further includes: performing a third deposition on the first surface 11; performing a third drive-in treatment; performing a fourth deposition on the first surface 11; and performing a fourth drive-in treatment.

The third deposition may be the same as or different from the first deposition. The third drive-in treatment may be the same as or different from the first drive-in treatment. The fourth deposition may be the same as or different from the second deposition. The fourth drive-in treatment may be the same as or different from the second drive-in treatment.

Another embodiment of the present invention provides a photovoltaic module, including: a cover plate; at least one cell string, and an encapsulation layer. The cell string includes any one of the foregoing photovoltaic cells, or a photovoltaic cell manufactured by any one of the foregoing methods. The encapsulation layer is located between the cover plate and the solar cell string, and the cover plate is connected to the solar cell string through the encapsulation layer.

The following are specific examples.

### Example 1

Manufacturing method of a photovoltaic module:
(1) Providing an N-type silicon wafer, and texturing a front surface of the N-type silicon wafer to form a pyramid textured surface.
(2) Performing a first deposition on the front surface of the silicon wafer at a deposition temperature of 830° C, a boron chloride flow rate of 300 sccm, an oxygen flow rate of 500 sccm, a nitrogen flow rate of 1000 sccm, a pressure of 200 mbar, and a deposition time of 15 min to reach a surface boron element close to a saturated state, and a surface boron element concentration reaching 1.5× 10²⁰.
(3) Performing a first drive-in treatment under a nitrogen atmosphere of (20L), a pressure of 800 mbar, a drive-in activation temperature of 870° C, a drive-in time of 15 min, a drive-in activation junction depth of 130 nm, and a doping concentration of boron element on the surface after the first drive-in treatment is 7.4× 10¹⁹.
(4) Performing a second deposition on the front surface of the silicon wafer at a deposition temperature of 870° C., a flow rate of boron chloride of 300 sccm, a flow rate of oxygen of 500 sccm, a flow rate of nitrogen of 1000 sccm, a pressure of 200 mbar, and a deposition time of 10 min, so that the surface boron element is close to the saturated state again, and the concentration of the surface boron element is 1.5× 10²⁰ again.
(5) Performing a second drive-in treatment under a nitrogen atmosphere of (20L), a pressure of 800 mbar, a drive-in activation temperature of 890° C., a drive-in time of 5 min, a drive-in activation junction depth of 230 nm, and a near-surface boron doping concentration of 1.2× 10²⁰ after the second drive-in treatment, to achieve a near-saturated doped surface state.
(6) Performing local laser heat treatment on the doped layer, wherein the laser wavelength is 1064 nm, the boron source in the laser treatment region is advanced into the deeper crystalline silicon body, the surface boron doping concentration is reduced to 3× 10¹⁹, and the doping depth reaches 1.4µm.
(7) Performing alkali etching on the front surface of the silicon wafer to remove the doped silicon after the laser heat treatment to form a patterned doped region 20.
(8) Preparing a first passivation anti-reflection layer on the front surface of the silicon wafer, and preparing a first electrode 30 on the first passivation anti-reflection layer, wherein the first electrode 30 is in electrical contact with the doped region 20.
(9) Preparing a back structure of the photovoltaic cell to obtain the photovoltaic cell.

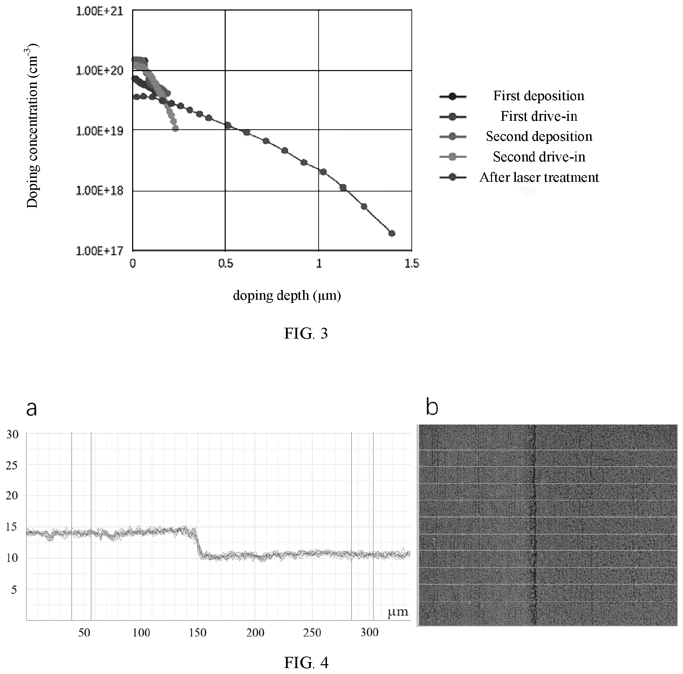

Referring to FIG. 3, which is a graph showing the relationship between the doping concentration and the doping depth in Example 1, it can be seen that the doping depth in step 6 can reach 1.4µm. Referring to FIG. 4, FIG. 4 is a test result diagram of the depth of the groove 15 in Example 1, and it can be seen that the depth of the groove 15 formed by removing the doped silicon after the laser heat treatment is about 3µm.

### Comparative Example 1

The manufacturing method of the photovoltaic cell in Comparative Example 1 was basically the same as that in Example 1, except that steps (2)-(7) were not performed, and the preparation steps of the doped region 20 were as follows:
(2) Depositing on the front surface of the silicon wafer at a deposition temperature of 830° C., a boron chloride flow rate of 300 sccm, an oxygen flow rate of 500 sccm, a nitrogen flow rate of 1000 sccm, a pressure of 200 mbar, a deposition time of 25 min, and a surface boron element concentration of 1.5× 10²⁰.
(3) The drive-in treatment was performed under a nitrogen atmosphere of (20L), a pressure of 800 mbar, a drive-in activation temperature of 910° C, a drive-in time of 15 min, a drive-in activation junction depth of 230 nm, and a doping concentration of boron element on a surface after the drive-in treatment was completed was 1× 1019; and the doped region 20 was prepared.

The photovoltaic cells prepared in Example 1 and Comparative Example 1 were subjected to performance tests, and the test results are shown in Table 1 below:

**Table 1**

| | Open circuit voltage/Uoc (mV) | short-circuit current/Isc (mA) | Filling factor/FF (%) | Conversion efficiency/Eta (%) |
|---|---|---|---|---|
| Example 1 | 742 | 42.3 | 84.2 | 26.42 |
| Comparative Example 1 | 736 | 42.1 | 83.9 | 26 |

It can be seen from the test results in Table 1 that the solar cell manufactured in Example 1 has higher conversion efficiency than the solar cell in Comparative Example 1. According to the method for manufacturing a photovoltaic cell in this application, the doped silicon region can be prepared to have a locally uniform high doping concentration in the region in contact with the electrode, so that high conversion efficiency of the photovoltaic cell can be achieved.

## Claims

1. A photovoltaic cell, comprising:
a silicon substrate having a first surface and a second surface that are opposite to each other, the first surface defining a first region and a second region, and the silicon substrate being provided with a groove in the second region;
a doped region located in the first surface and in the first region, and
a first electrode electrically connected to the doped region;
wherein in a thickness direction of the silicon substrate, a depth of the groove is in a range of 1.5µm to 3µm.

2. The photovoltaic cell according to claim 1, wherein a doping concentration of the doped region being in a range of 1.2× 10²⁰ cm⁻³ to 1.5×10²⁰cm⁻³.

3. The photovoltaic cell according to claim 1, wherein a thickness of the doped region is in a range of from 100 nm to 300 nm.

4. The photovoltaic cell according to claim 1, wherein the first surface has a textured structure, and the textured structure comprises a plurality of pyramid structures, optionally, radial widths of the plurality of pyramid structures gradually decrease in a direction away from the second surface.

5. The photovoltaic cell according to claim 4, wherein in the doped region, a doping concentration of a portion located at a bottom end of one of the plurality of the pyramid structures is less than or equal to a doping concentration of a portion located at a top end of the pyramid structure;
optionally, a difference between a doping concentration of the portion located at the bottom end of the pyramid structure and the doping concentration of the portion located at the top end of the pyramid structure is less than or equal to 1× 10²⁰ cm⁻³.

6. The photovoltaic cell according to claim 1, further comprising a tunneling oxide layer and a doped silicon layer that are sequentially stacked on the second surface, and a plurality of second electrodes provided on the doped silicon layer, wherein the plurality of second electrodes are electrically connected to the doped silicon layer.

7. The photovoltaic cell according to claim 1, wherein the second surface defines a third region and a fourth region, the photovoltaic cell further comprises a tunneling oxide layer, a doped silicon layer, and a second electrode that are sequentially stacked on the second surface and located in the third region, and the second electrode is electrically connected to the doped silicon layer.

8. A method for manufacturing a photovoltaic cell, comprising:
providing a silicon substrate, the silicon substrate having a first surface and a second surface opposite to each other, the first surface comprising a first region and a second region;
performing a first deposition on the first surface;
performing a first drive-in treatment;
performing a second deposition on the first surface; and
performing a second drive-in treatment; and
performing a laser heat treatment on the first surface located in the second region; and
performing a first etching treatment on an entire surface of the first surface by using a first alkaline solution, so as to form a groove in a portion of the first surface located in the first region.

9. The method according to claim 8, wherein the first drive-in treatment reduces a concentration of a doping element on the first surface by more than 30%.

10. The method according to claim 8, wherein the first drive-in treatment enables a doping element to have a depth of 50 nm to 150 nm into the substrate.

11. The method according to claim 8, wherein the second drive-in treatment enables a doping element to have a depth of 50 nm to 100 nm into the substrate.

12. The method according to claim 8, wherein after performing the second drive-in treatment and prior to performing a laser heat treatment, the method further comprises:
performing a third deposition on the first surface;
performing a third drive-in treatment;
performing a fourth deposition on the first surface; and
performing a fourth drive-in treatment.

13. The method according to claim 8, wherein the laser heat treatment causes a doping element to defuse into the silicon substrate to a depth of 1.4µm or more;
and/or the laser heat treatment reduces a doping concentration at the first surface in the second region to less than 25% of a doping concentration after the first deposition.

14. The method according to claim 8, wherein the first etching process reduces the thickness of the silicon substrate in the second region by 1.5µm to 3µm.

15. A photovoltaic module, comprising:
a cover plate;
at least one cell string comprising the photovoltaic cell according to any one of claims 1 to 7; and
an encapsulation layer located between the cover plate and the at least one cell string, and
the cover plate being connected to the at least one cell string through the encapsulation layer.
